# EUROPEAN PATENT APPLICATION

(11) **EP 4 451 341 A1**
(43) Date of publication of application: **23.10.2024**
(21) Application number: 22906320.1
(22) Date of filing: 06.12.2022
(51) Int. Cl.: H01L 29/778, H01L 29/06, H03F 3/195

(54) **PSEUDOMORPHIC HIGH ELECTRON MOBILITY TRANSISTOR, LOW-NOISE AMPLIFIER AND RELATED DEVICE**

(30) Priority: 14.12.2021 CN 202111529775
(71) Applicant: Huawei Technologies Co., Ltd., Shenzhen, Guangdong 518129 (CN)
(72) Inventor: YU, Minglang, Shenzhen, Guangdong 518129 (CN); TENG, Teng, Shenzhen, Guangdong 518129 (CN); YE, Jianwei, Shenzhen, Guangdong 518129 (CN); YU, Jie, Shenzhen, Guangdong 518129 (CN); ZHOU, Xiaomin, Shenzhen, Guangdong 518129 (CN); XU, Yusi, Shenzhen, Guangdong 518129 (CN)
(74) Representative: Huawei European IPR
(86) International application number: PCT/CN2022/136830
(87) International publication number: WO 2023/109570

(57) **Abstract**

This application provides a pseudomorphic high electron mobility transistor PHEMT, a low noise amplifier, and a related apparatus. The PHEMT includes a channel layer; a lower barrier layer and an upper barrier layer that are respectively disposed on two sides of the channel layer, where the lower barrier layer is connected to the channel layer; and a first isolation layer and a first doped layer that are disposed between the channel layer and the upper barrier layer, where the first isolation layer is configured to isolate the first doped layer from the channel layer, and the first doped layer is configured to provide two-dimensional electron gas. When an output current of the PHEMT is less than a first threshold, a conduction band energy level of the channel layer is less than a Fermi energy level. This improves linearity of the PHEMT under a small output current, and reduces intermodulation distortion caused by LNA nonlinearity.

## Description

This application claims priority to Chinese Patent Application No. 202111529775.4, filed with the China National Intellectual Property Administration on December 14, 2021 and entitled "PSEUDOMORPHIC HIGH ELECTRON MOBILITY TRANSISTOR, LOW NOISE AMPLIFIER, AND RELATED APPARATUS", which is incorporated herein by reference in its entirety.

### TECHNICAL FIELD

This application relates to the field of semiconductor device technologies, and in particular, to a pseudomorphic high electron mobility transistor, a low noise amplifier, and a related apparatus.

### BACKGROUND

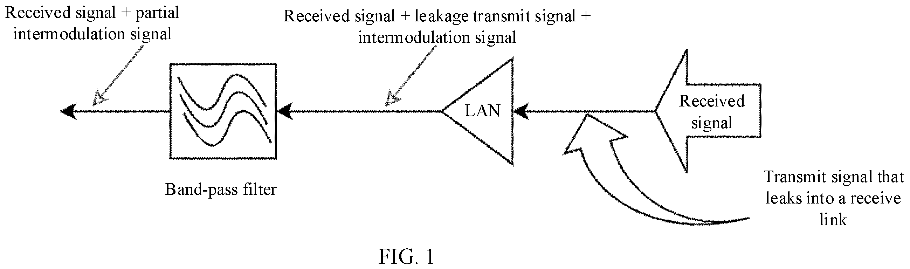

As shown in FIG. 1, when a received signal passes through a low noise amplifier LNA, the received signal on a receive link of an antenna end of a wireless communication product and a transmit signal that leaks into the receive link generate an intermodulation signal, causing intermodulation distortion (intermodulation distortion, IMD). This is caused by a nonlinear characteristic of the LNA. Because a frequency of the 3^{rd} order intermodulation product is very close to a frequency of the received signal, the 3^{rd} order intermodulation product cannot be suppressed by a subsequent filter in the receive link, causing interference to the received signal on the link.

### SUMMARY

Embodiments of this application provide a pseudomorphic high electron mobility transistor PHEMT, a low noise amplifier, and a related apparatus. When an output current of the PHEMT is less than a first threshold, a conduction band energy level of the channel layer is less than a Fermi energy level. This improves linearity of the PHEMT under a small output current, and reduces intermodulation distortion caused by LNA nonlinearity.

According to a first aspect, an embodiment of this application provides a pseudomorphic high electron mobility transistor PHEMT, including:
a channel layer;
a lower barrier layer and an upper barrier layer that are respectively disposed on two sides of the channel layer, where the lower barrier layer is connected to the channel layer; and
a first isolation layer and a first doped layer that are disposed between the channel layer and the upper barrier layer, where the first isolation layer is configured to isolate the first doped layer from the channel layer, and the first doped layer is configured to provide two-dimensional electron gas; and
when an output current of the PHEMT is less than a first threshold, a conduction band energy level of the channel layer is less than a Fermi energy level.

An energy level structure of the channel layer in the PHEMT is adjusted, so that when the output current of the PHEMT is less than the first threshold, the conduction band energy level of the channel layer is less than the Fermi energy level. This improves linearity of the PHEMT under a small output current, and reduces intermodulation distortion caused by LNA nonlinearity.

In a possible implementation, the lower barrier layer is directly connected to the channel layer.

The lower doped layer in the PHEMT is removed, so that a gradient of an energy level of the channel layer in a thickness direction is smaller, and the conduction band energy level of the channel layer is less than the Fermi energy level during operation under a small current.

In a possible implementation, the first doped layer is silicon doped, and a doping concentration is 3 e¹²cm ²to 5 e¹²cm ⁻².

In a possible implementation, the doping concentration of the first doped layer is 5 e¹²cm ⁻²to 6 e¹²cm 2

The concentration of the first doped layer in the PHEMT is increased, so that a gain of the PHEMT is increased.

In a possible implementation, the lower barrier layer is connected to the channel layer through a second isolation layer and a second doped layer, the second isolation layer is configured to isolate the channel layer from the second doped layer, and the second doped layer is configured to provide two-dimensional electron gas.

The PHEMT is a double doped PHEMT, for example, a double δ doped PHEMT.

In a possible implementation, a doping concentration of the first doped layer is 3.5 e¹²cm ⁻²to 4.5 e¹²cm ², and a doping concentration of the second doped layer is 3 e¹¹cm ⁻² to 5 e¹¹cm ⁻².

In a possible implementation, a doping concentration of the first doped layer is 4 e¹²cm ⁻² to 6 e¹²cm ⁻², and a doping concentration of the second doped layer is 2 e⁸cm ⁻² to 3 e¹¹cm ⁻².

In a possible implementation, a ratio of a doping concentration of the first doped layer to a doping concentration of the second doped layer is greater than a preset value.

Optionally, the preset value is a positive number greater than 6, for example, 9, 10, 15, 30, 70, 100, or 150.

If a total doping concentration in the PHEMT remains unchanged or does not decrease, the doping concentration of the lower doped layer (the second doped layer) is reduced, or the ratio of the doping concentration of the upper doped layer (the first doped layer) to the doping concentration of the lower doped layer (the second doped layer) is increased, so that a gradient of an energy level of the channel layer in a thickness direction is smaller, and the conduction band energy level of the channel layer is less than the Fermi energy level during operation under a small current.

In a possible implementation, a thickness of the channel layer is 15-20 nm, 18-20 nm, or 20-25 nm, for example, 18 nm.

In a possible implementation, when the output current of the PHEMT is less than a second threshold, the conduction band energy level of the channel layer decreases substantially in the thickness direction.

The thickness of the channel layer in the PHEMT is increased, so that accumulation of electrons under the channel layer when the device operates is avoided, and electrons are distributed more evenly. This improves linearity of the PHEMT.

In a possible implementation, the PHEMT further includes: a cap layer, a source, a drain, and a gate, where the cap layer is disposed on a side of the upper barrier layer away from the channel layer and provided with a through hole for providing ohmic contact, the gate is disposed in the through hole, and the source and the drain are both disposed on a side of the cap layer away from the upper barrier layer, and are respectively located on two sides of the through hole.

In a possible implementation, the channel layer is made of indium gallium arsenide, and the upper barrier layer, the lower barrier layer, or the isolation layer is made of aluminum gallium arsenide.

According to a second aspect, an embodiment of this application further provides a low noise amplifier, including the PHEMT according to any one of the first aspect or the possible implementations of the first aspect.

According to a third aspect, an embodiment of this application further provides a radio frequency circuit, including the low noise amplifier according to the second aspect.

According to a fourth aspect, an embodiment of this application further provides a radio frequency chip, including at least one of the PHEMT according to any one of the first aspect or the possible implementations of the first aspect, the low noise amplifier according to the second aspect, and the radio frequency circuit according to the third aspect.

According to a fifth aspect, an embodiment of this application further provides an electronic device, including at least one of the PHEMT according to any one of the first aspect or the possible implementations of the first aspect, the low noise amplifier according to the second aspect, the radio frequency circuit according to the third aspect, and the radio frequency chip according to the fourth aspect.

### BRIEF DESCRIPTION OF DRAWINGS

To describe the technical solutions in embodiments of this application more clearly, the following briefly describes the accompanying drawings for describing embodiments.
FIG. 1 is a schematic illustrative diagram of an intermodulation signal generated on an antenna end receive link according to an embodiment of this application;
FIG. 2A is a schematic diagram of a structure of a double δ doped PHEMT according to a conventional technology;
FIG. 2B is an example diagram of a direct current output characteristic curve of the PHEMT shown in FIG. 2A;
FIG. 2C is a schematic diagram of energy band structures of a PHEMT shown in FIG. 2A;
FIG. 2D is an example diagram of a curve of an OIP3 value of the PHEMT shown in FIG. 2A under different output currents;
FIG. 3 is a schematic diagram of defining an OIP3 value in the conventional technology;
FIG. 4 is a schematic diagram of a structure of a cross section of a single δ doped PHEMT according to an embodiment of this application;
FIG. 5 is a schematic diagram of a structure of a cross section of a double δ doped PHEMT according to an embodiment of this application;
FIG. 6 is an example diagram of curves of OIP3 values of a double δ doped PHEMT according to the conventional technology and a single δ doped PHEMT according to an embodiment of this application respectively under different output currents;
FIG. 7A is an example diagram of an energy band of a double δ doped PHEMT according to the conventional technology;
FIG. 7B is an example diagram of an energy band of a single δ doped PHEMT according to an embodiment of this application;
FIG. 7C is an example diagram of a conduction band structure of a single δ doped PHEMT and a double δ doped PHEMT at a channel layer according to an embodiment of this application;
FIG. 8 is a diagram of electron concentration distribution of double δ doped PHEMTs whose channel layers are respectively 12 nm and 18 nm thick under an output current of 60 mA/mm;
FIG. 9 is a schematic diagram of a circuit structure of an LNA according to an embodiment of this application; and
FIG. 10 is a schematic diagram of a radio frequency system according to an embodiment of this application.

### DESCRIPTION OF EMBODIMENTS

Generally, there are two methods to reduce interference caused by an intermodulation signal to a received signal.

In one method, isolation of a duplexer is increased to reduce leakage of a transmit signal into a receive link. The duplexer is also referred to as a diplexer, and functions to isolate a transmit signal sent by a shared antenna from a received signal received by the shared antenna, to ensure that both a transmit link and the receive link can simultaneously operate. If isolation of the duplexer is increased to reduce interference caused by an intermodulation signal to a received signal, a cavity of the duplexer needs to be enlarged. This increases a size of the duplexer, and also greatly increases costs.

In the other method, linearity of a low noise amplifier (LNA) is improved to reduce an intermodulation signal that is generated by the leakage signal and the received signal and that cannot be completely suppressed by a filter. Linearity of the LNA is determined by a core of a transistor. The transistor may use a pseudomorphic high electron mobility transistor (pseudomorphic high electron mobility transistor, PHEMT).

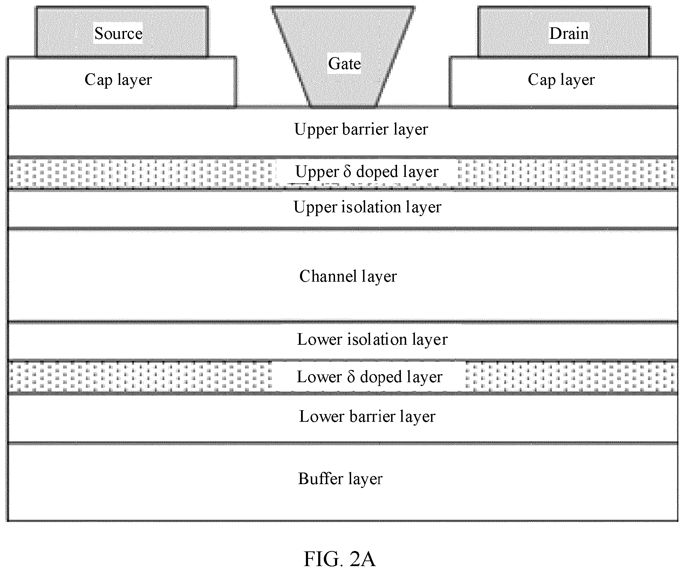

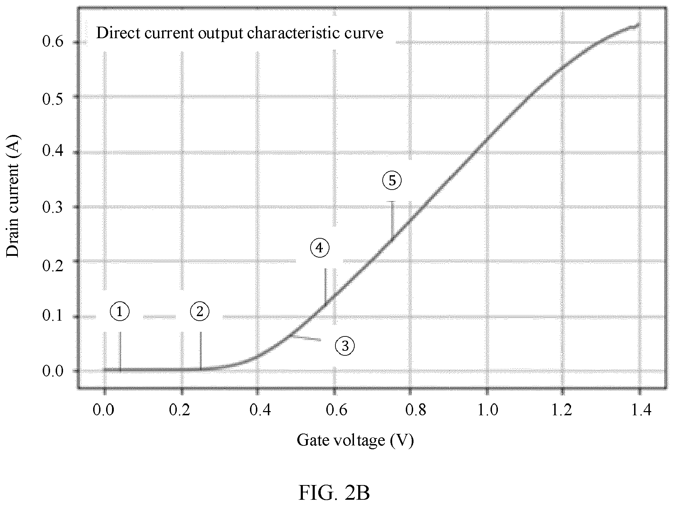

FIG. 2A shows a typical structure of a gallium arsenide (GaAs)-based PHEMT. Epitaxial layers of a core of the PHEMT are respectively a buffer layer (buffer layer), a lower barrier layer, a lower δ doped layer, a lower isolation layer, a channel layer (channel layer), an upper isolation layer, an upper δ doped layer, an upper barrier layer, and a cap layer from top to bottom. For the gallium arsenide (GaAs)-based PHEMT, the buffer layer on a substrate may be made of gallium arsenide or aluminum gallium arsenide, and is configured to prevent a defect of the substrate from entering another layer of the PHEMT. The lower barrier layer and the upper barrier layer may be made of aluminum gallium arsenide (AlGaAs), and are configured to prevent two-dimensional electron gas from entering the buffer layer. Both the lower δ doped layer and the upper δ doped layer may be silicon (Si) doped, and are configured to provide two-dimensional electron gas. The upper isolation layer and the lower isolation layer may be made of aluminum gallium arsenide (AlGaAs), and are configured to isolate the doped layers from the channel layer. The channel layer may be made of indium gallium arsenide (InGaAs). The cap layer may be made of highly doped gallium arsenide, and connects a source and a drain. An electron concentration in the channel layer is controlled by using a gate voltage, so that an output current between the source and the drain can be controlled. This implements a signal amplification function. FIG. 2B shows a direct current output characteristic curve of the PHEMT shown in FIG. 2A. For example, five different gate voltages are marked in FIG. 2B, to respectively distinguish five operation states of the PHEMT: an off state ①, a to-be-on state ②, an on state ③, a fully on state ④, and a linear operation state ⑤.

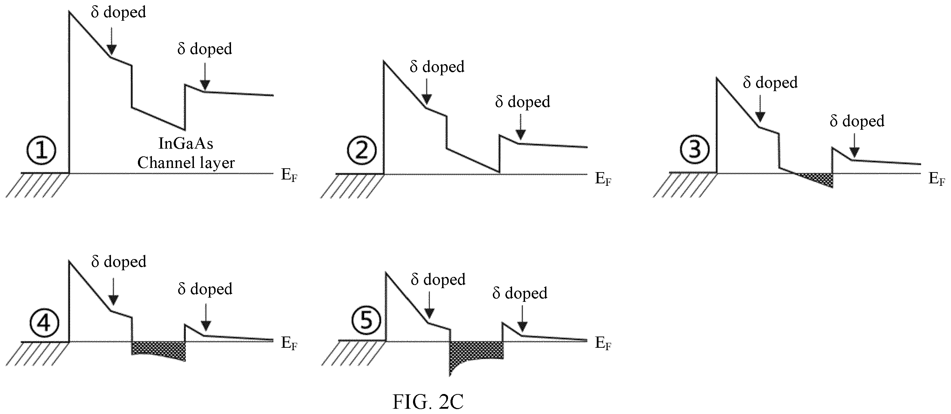

FIG. 2C is a schematic diagram of energy band structures of the PHEMT shown in FIG. 2A in five different operation states. It should be understood that a diagram of each energy band structure in FIG. 2C merely illustrates a conduction band structure of all layers, sequentially including conduction bands of the cap layer, the upper barrier layer, the upper δ doped layer, the upper isolation layer, the channel layer, the lower isolation layer, the lower δ doped layer, and the lower barrier layer from left to right, that is, in a thickness direction. Only locations of the upper δ doped layer, the lower δ doped layer, and the channel layer are marked in the figure.

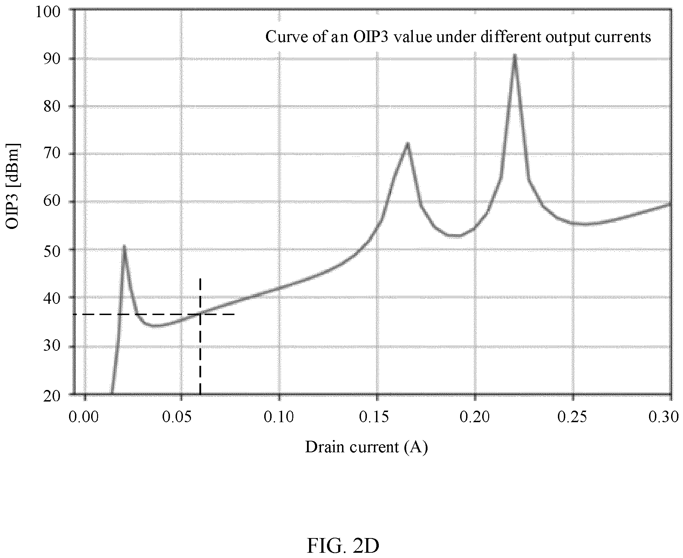

As shown in FIG. 2C, when the PHEMT is in the off state ①, a conduction band energy level of the channel layer is far greater than a Fermi energy level Ef. As a gate voltage increases, when the PHEMT is in the to-be-on state ②, the conduction band energy level of the channel layer approaches the Fermi energy level Ef. As the gate voltage further increases, when the conduction band energy level of the channel layer is partially less than the Fermi energy level Ef, a specific quantity of free electrons appear in the channel layer. In this case, the PHEMT is in the on state ③. As the gate voltage further increases, a conduction band structure in the channel layer changes from a left-high and right-low form in the on state ③ to a form in the fully on state ④ and a form in the linear operation state ⑤ in sequence. That is, carriers tend to be located on an upper side of the channel layer (namely, the left side in FIG. 2D, that is, a side adjacent to the upper isolation layer).

However, to meet requirements of low power consumption and low noise in a receive link of a radio frequency system, an LNA substantially operates in a state in which an output current density is limited to 60-100 mA/mm, that is, in the on state ③ of the PHEMT in FIG. 2C.

To meet requirements of low power consumption and a low noise coefficient of the LNA in a radio frequency circuit, an output current of operation points is substantially limited to 60-100 mA/mm. Due to the characteristic of high electron mobility, the PHEMT can reach an operation state current with only a small concentration of two-dimensional electron gas. As a result, most operation points are near a turn-on voltage of the PHEMT. However, linearity of the PHEMT in this range is small, and cannot meet an application requirement. Linearity of the PHEMT is represented by an output 3^{rd} order intercept point (output 3rd^{rd} order intercept point, OIP3). A higher OIP3 indicates higher linearity. As shown in FIG. 2D, a curve of an OIP3 value of the PHEMT shown in FIG. 2A under different output currents may be obtained through calculation based on the direct current output characteristic curve shown in FIG. 2B. It may be learned from FIG. 2D that, when an output current is 60 mA, an OIP3 value of the PHEMT is approximately 36 dBm, and cannot meet a requirement of being not less than 41 dBm. Therefore, how to improve linearity of the device when the output current is small, that is, when the PHEMT is just turned on, is an urgent technical problem to be resolved currently.

The following describes technical terms in embodiments of this application.

### (1) LNA

The LNA is an important circuit of a wireless communication system and an amplifier with a quite low noise coefficient, and functions to amplify signals received by an antenna. The received signals from the antenna are weak. To amplify such weak signals, it is most important to ensure signal quality. For this purpose, the LNA cannot introduce too much noise. Otherwise, the signals will be further deteriorated and demodulation cannot be performed.

Most LNAs use transistors and field effect transistors. In embodiments of this application, the LNA uses a pseudomorphic high electron mobility transistor (pseudomorphic high electron mobility transistor, PHEMT).

### (2) Intermodulation signal

The intermodulation signal is an intermodulation frequency signal generated when a non-modulation signal and a useful signal pass through a nonlinear device and then interact with each other. Because a frequency of the intermodulation signal is very close to that of the useful signal, a back-end filter can hardly suppress the intermodulation signal. As shown in FIG. 1, when a received signal (namely, a useful signal) and a transmit signal (namely, an interference signal) that leaks into a receive link simultaneously pass through an LNA, due to nonlinear effect, a frequency of an intermodulation signal generated by the two signals sometimes is exactly equal to or close to a frequency of the received signal, and consequently the intermodulation signal smoothly passes through a receiver. A 3^{rd} order intermodulation signal causes most severe interference, which is referred to as intermodulation interference.

### (3) PHEMT

The PHEMT is an improvement to a high electron mobility transistor (high electron mobility transistor, HEMT). The PHEMT has a double heterojunction structure, and two-dimensional electron gas 2DEG of the PHEMT has double limiting effect on both sides of a potential well. Therefore, compared with an HEMT, the PHEMT has a higher electron surface density, and also has higher electron mobility.

FIG. 2A shows a typical double δ doped PHEMT.

### (4) OIP3

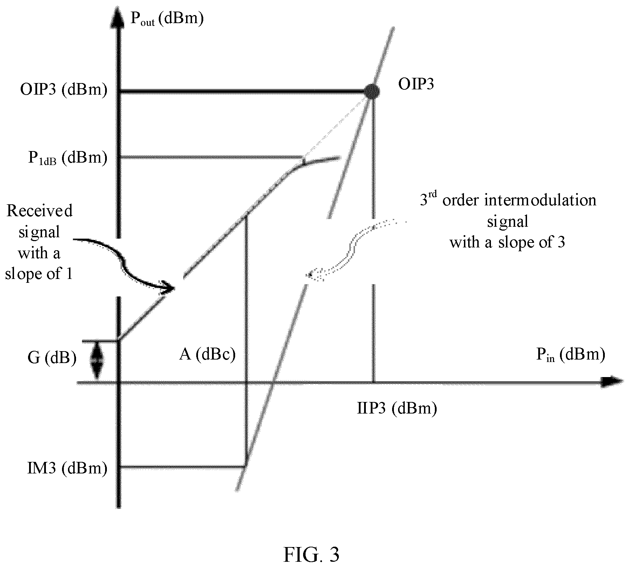

Linearity of the PHEMT may be represented by an output 3^{rd} order intercept point (output 3rd^{rd} order intercept point, OIP3). Ahigher OIP3 value indicates higher linearity. The OIP3 value may be obtained from a PHEMT radio frequency input and output curve through drawing. As shown in FIG. 3, specifically two curves are drawn. One curve is a curve of an amplification signal power at an input frequency to an input power, and the other curve is a curve of a 3^{rd} order intermodulation signal to the input power. In a logarithmic coordinate system, the curve of a linear amplification signal is represented as a straight line with a slope of 1, and the curve of the 3^{rd} order intermodulation signal is represented as a straight line with a slope of 3. An output signal power corresponding to an intersection point of the two curves is the OIP3 value.

### (5) Output current

The output current in embodiments of this application is also referred to as a current that is output from a drain. A small output current is also briefly referred to as a small current. The small output current means that the output current is less than a first threshold or less than a second threshold, where the first threshold or the second threshold may be a current density existing when the PHEMT is just turned on. Alternatively, the small output current means that an output current density of the PHEMT is 40-200 mA/mm or 60-100 mA/mm. The first threshold may be equal to or not equal to the second threshold. An example in which a small output current is 60 mA/mm is described in embodiments of this application. A current in embodiments of this application also refers to a current density.

In embodiments of this application, thicknesses, materials, and the like of all layer structures in the PHEMT are designed, and especially thicknesses of epitaxial layers, doping concentrations of doped layers, and other structures are designed, so that the energy band structure of the channel layer of the PHEMT is adjusted. Therefore, when the PHEMT operates under a small output current, the conduction band energy level of the channel layer is less than the Fermi energy level. As a gate voltage increases, the increase of an electron concentration near the Fermi energy level has less effect on an electron concentration of the channel layer. This improves linearity of the PHEMT. From the perspective of a conduction band structure, a conduction band gradient of the channel layer is smaller in the on state ③.

The following describes an adjustment mechanism of an energy band structure of a channel layer.

There are the following several main factors that affect an energy band structure of a channel layer:
a: Distance between a channel layer and a gate. The distance affects an energy level of the channel layer
b: Doping concentrations of upper/lower doped layers. A doped layer changes a bending degree of an energy band of a structure over the doped layer. For example, if a doping concentration of an upper doped layer increases, a bending degree of an energy band of an upper barrier layer is larger, and a gradient of an energy level of the upper barrier layer in a thickness direction is larger For another example, if a doping concentration of a lower doped layer increases, a bending degree of an energy band of the channel layer is larger, and a gradient of an energy level of the channel layer in a thickness direction is larger. Therefore, the concentration of the lower doped layer is reduced, so that the bending degree of the energy band of the channel layer is larger, the gradient of the energy level of the channel layer in the thickness direction is larger, and the conduction band energy level of the channel layer is less than the Fermi energy level during operation under a small output current.
c: Ratio of doping concentrations of upper/lower doped layers. To meet the requirement that a conduction band energy level of a channel layer is less than a Fermi energy level when the PHEMT operates under a small current, a doping concentration of a lower doped layer is reduced. However, a total doping concentration of the upper/lower doped layers affects a carrier concentration. This affects performance of the device. In addition, a larger doping concentration indicates a higher turn-on voltage of the device. Therefore, the total doping concentration cannot be excessively low or excessively high.
d: Thickness of a channel layer. The thickness of the channel layer affects distribution of electrons and currents. With a thick channel layer, electrons accumulated under the channel layer when the device operates can be avoided, so that electrons are more evenly distributed. This improves linearity of the PHEMT.

Therefore, with reference to the foregoing several factors, embodiments of this application provide the following several solutions to adjust the energy band structure of the channel layer. Therefore, when the PHEMT operates under a small current, the conduction band energy level of the channel layer is less than the Fermi energy level.

Solution 1: The lower doped layer is removed, so that the gradient of the energy level of the channel layer in the thickness direction is smaller, and the conduction band energy level of the channel layer is less than the Fermi energy level during operation under a small current.

Solution 2: If the total doping concentration does not decrease, the doping concentration of the lower doped layer is reduced, or the ratio of the doping concentration of the upper doped layer to the doping concentration of the lower doped layer is increased.

Solution 3: The thickness of the channel layer is increased.

There may be a combination of the foregoing solutions 1, 2, and 3, a combination of adjustment of a thickness of the upper barrier layer and/or a thickness of the upper isolation layer and at least one of the foregoing solutions 1, 2, and 3, and the like.

In the foregoing solutions, thicknesses and doping concentrations of all layer structures in the PHEMT are adjusted, so that the conduction band energy level of the channel layer is less than the Fermi energy level during operation under a small current. In this way, linearity of the PHEMT can be improved, linearity of an LNA formed by the PHEMT can be improved, an intermodulation signal output by the LNA can be reduced, and signal quality can be improved.

The following clearly and in detail describes embodiments of this application with reference to the accompanying drawings in embodiments of this application.

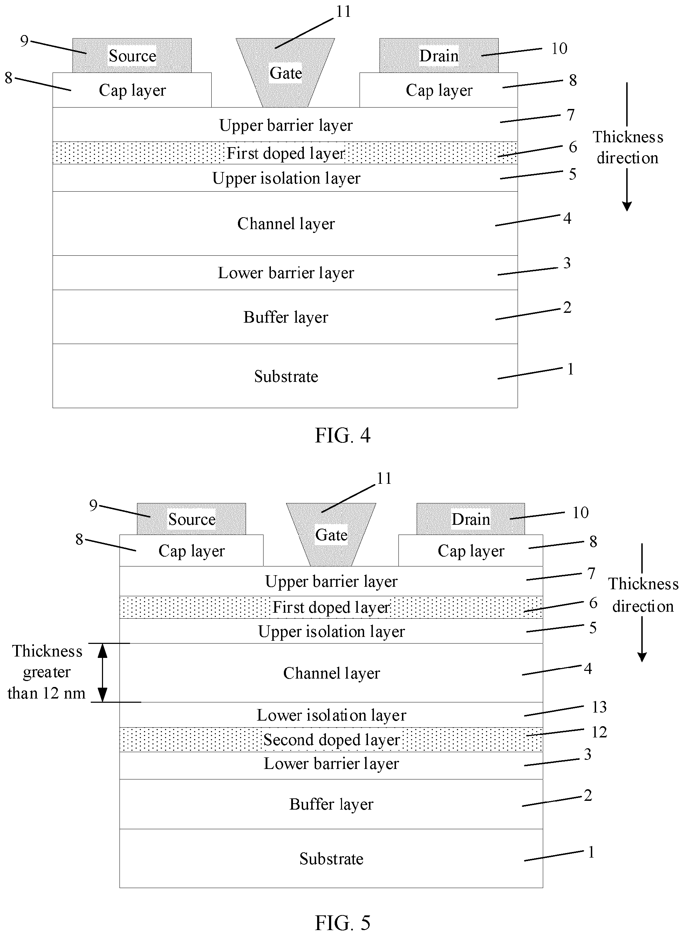

FIG. 4 is a schematic diagram of a structure of a cross section of a PHEMT. The energy band structure of the channel layer is adjusted by using the foregoing solution 1, or a combination of the foregoing solution 1 and at least one of the adjustment of the thickness of the upper barrier layer and/or the thickness of the upper isolation layer, the foregoing solution 2, and the foregoing solution 3.

As shown in FIG. 4, the PHEMT is single δ doped, and includes: a substrate 1; a buffer layer 2, a lower barrier layer 3, a channel layer 4, an upper isolation layer 5, a first doped layer 6, an upper barrier layer 7, and a cap layer 8 that are sequentially disposed on the substrate 1; a source 9 and a drain 10 that are disposed on the cap layer 8; and a gate electrode 11 disposed on the upper barrier layer 7. The following uses the GaAs-based PHEMT as an example to describe functions, compositions, thicknesses, and the like of each layer.

The substrate 1 may be a gallium arsenide (GaAs) wafer.

The buffer layer 2 may be made of gallium arsenide (GaAs) or aluminum gallium arsenide (AlₓGaₗ₋ₓAs), where 0 < x < 1. The buffer layer 2 can prevent a defect of the substrate 1 from entering a core of the PHEMT. Generally, a doping concentration of Al in the buffer layer gradually increases in a direction away from the substrate 1, so that a defect caused by a lattice mismatch between the substrate 1 and the lower barrier layer 3 can be reduced.

The lower barrier layer 3 may be made of aluminum gallium arsenide (AlₓGaₗ₋ₓAs). A band gap width of the lower barrier layer 3 is greater than a band gap width of the channel layer 4. The lower barrier layer 3 and the channel layer 4 form a heterojunction that is a negative junction. A thickness of the lower barrier layer 3 may be 10-50 nm or 10-25 nm, for example, 17 nm, 20 nm, or the like.

For example, a maximum doping concentration of Al in the buffer layer 2 is not greater than a doping concentration of Al in the lower barrier layer 3.

The channel layer 4 may be made of indium gallium arsenide (In_{y}Gaₗ-_{y}As), where 0 < y < 1. For example, a value range of y may be 0.1-0.5. For example, y is 0.22 or 0.3.

In some embodiments, a thickness of the channel layer 4 may be greater than 8 nm or 12 nm and less than a critical thickness of a channel epitaxial layer. For example, a critical thickness of a channel layer made of In₀.₂₂Ga₀.₇₈As is approximately 20 nm. The critical thickness increases as indium content decreases. Optionally, the thickness of the channel layer 4 may be 8-30 nm, 12-30 nm, or 15-20 nm, for example, 17 nm, 18 nm, 20 nm, 24 nm, or the like. The thickness of the channel layer 4 is increased, so that distribution of electrons and currents in the channel layer 4 can be improved. This avoids accumulation of electrons under the channel layer 4, reduces a current in a longitudinal direction (namely, a stacking direction of the PHEMT), and improves linearity of the PHEMT.

For example, the channel layer 4 is made of In₀.₂₂Ga₀.₇₈As, and the thickness is 18 nm.

The upper isolation layer 5 is configured to isolate the channel layer 4 from the first doped layer 6, to prevent doping impurities of the first doped layer 6 from entering the channel layer 4. The upper isolation layer 5 may be made of aluminum gallium arsenide, and the thickness may be 2-6 nm, for example, 4 nm or 6 nm. The upper isolation layer 5 is also referred to as a first isolation layer.

The first doped layer 6 may be δ doped and is also referred to as an upper δ doped layer. The first doped layer 6 may be silicon doped. A thin layer of silicon grows on the upper isolation layer 5 as doping impurities, to provide two-dimensional electron gas after being ionized. The first doped layer 6 may be several atoms thick, and the thickness is less than 2 nm, for example, 1 nm or less than 1 nm.

For example, a doping concentration of the first doped layer 6 is a sum of doping concentrations of two doped layers in a double δ doped PHEMT in a conventional technology, or the doping concentration is 3 e¹²cm ⁻² to 5 e¹²cm ⁻², 5 e¹²cm ^{- 2}to 6 e¹²cm ⁻², 1e¹²cm ⁻²to 3 e¹²cm ⁻²,4.6 e¹²cm ⁻²to 5.5 e¹²cm ⁻², or 5.5 e¹²cm ⁻²to 6.5 e¹²cm ⁻², for example, 4.5 e¹²cm⁻².

The upper barrier layer 7 may be made of aluminum gallium arsenide (AlₓGaₗ₋ₓAs). A band gap width of the upper barrier layer 7 is greater than the band gap width of the channel layer 4. The upper barrier layer 7, the first doped layer 6, the upper isolation layer 5, and the channel layer 4 form a heterojunction that is a positive junction. A thickness of the upper barrier layer 7 may be 10-30 nm or 10-25 nm, for example, 15 nm, 17 nm, 20 nm, or the like.

The cap layer 8 may be made of highly doped gallium arsenide (n+-GaAs), and the thickness may be 5-10 nm. The cap layer 8 is configured to provide ohmic contact.

The cap layer 8 is provided with a through hole. The gate 11 is disposed in the through hole and is not in contact with the cap layer 8. The source 9 and the drain 10 are both disposed on a side of the cap layer 8 away from the upper barrier layer 7 and are respectively located on two sides of the through hole.

The source 9, the drain 10, and the gate 11 are all made of conductive metal. The gate 11 is configured to provide a gate voltage for the PHEMT. When the gate voltage is greater than a turn-on voltage, the source 9 and the drain 10 are connected, and a drain current is output.

In this embodiment of this application, the lower barrier layer 3 is directly connected to the channel layer 4. Herein, "direct connection" means direct contact. In other words, no other layer structure is included between the lower barrier layer 3 and the channel layer 4.

It should be noted that, although the buffer layer 2, the lower barrier layer 3, the upper isolation layer 5, and the upper barrier layer 7 may all use aluminum gallium arsenide (AlₓGa₁₋ₓAs), doping concentrations of Al in the layers may be the same or different. This is not limited herein. For example, the lower barrier layer 3, the upper isolation layer 5, and the upper barrier layer 7 all use Al₀.₂₂Ga₀.₇₈As.

According to the single δ doped PHEMT provided in this embodiment of this application, because the band gap width of the upper barrier layer 7 and the band gap width of the lower barrier layer 3 are both greater than the band gap width of the channel layer 4, the single δ doped PHEMT has one doped positive junction (the upper barrier layer 7/the first doped layer 6/the upper isolation layer 5/the channel layer 4) and one undoped negative junction (the channel layer 4/the lower barrier layer 3). When the gate voltage is greater than the turn-on voltage, doping impurities are ionized. Because the band gap width of the upper barrier layer 7 and the band gap width of the channel layer 4 are different, a conduction band is not continuous, and electrons are transferred to one side of the channel layer to form two-dimensional electron gas. The source 9 and the drain 10 are connected, and the drain current is output.

In this embodiment of this application, based on the foregoing adjustment mechanism of the energy band structure of the channel layer, the lower doped layer is removed, an appropriate concentration of the upper doped layer (namely, the first doped layer 6) is selected, and appropriate thicknesses of the channel layer 4, the upper barrier layer 7, and the upper isolation layer 5 are selected. For the obtained single δ doped PHEMT, when the output current is a small current, a conduction band energy level of the channel layer 4 is less than a Fermi energy level, or a conduction band energy level at a boundary between the channel layer 4 and the upper isolation layer 5 is less than a Fermi energy level. Optionally, for the PHEMT, when the output current is a small current, the conduction band energy level of the channel layer 4 substantially decreases in a thickness direction. In this embodiment of this application, the thickness direction is a direction from the cap layer to the substrate. Refer to the direction indicated in FIG. 4. The substantial decrease may include the following two cases:
1. The conduction band energy level of the channel layer 4 decreases in the thickness direction. In other words, a farther distance from the upper barrier layer indicates a smaller conduction band energy level.
2. The conduction band energy level of the channel layer 4 is substantially/macroscopically in a descending trend in the thickness direction. In other words, the conduction band energy level is allowed to be relatively high in a small region/microscopically farther from the upper barrier layer.

For example, the thickness of the upper barrier layer 7 is 3-7 nm. The thickness of the upper isolation layer 5 is 4 nm. The doping concentration of the first doped layer 6 is 3.0-4.5 e¹²cm ⁻². The thickness of the channel layer is 12 nm.

For example, the thickness of the upper barrier layer 7 is 5 nm. The thickness of the upper isolation layer 5 is 3-5 nm. The doping concentration of the first doped layer 6 is 3.0-4.5 e¹²cm ⁻². The thickness of the channel layer is 8-14 nm.

Different from the double δ doped PHEMT in the conventional technology, this embodiment of this application provides the single δ doped PHEMT. When the total doped concentration remains unchanged or does not decrease, δ doping is performed only on the upper barrier layer 7, and the lower doped layer is removed, to reduce a gradient of the conduction band energy level of the channel layer 4 in the thickness direction, so that linearity of the PHEMT under a small output current can be improved without affecting a gain (namely, a transconductance gm).

Further, the thickness of the channel layer 4 is increased, so that distribution of electrons and currents in the channel layer 4 can be improved. This avoids accumulation of electrons under the channel layer 4, reduces a current in a longitudinal direction (namely, a stacking direction of the PHEMT), and can further improve linearity of the PHEMT.

FIG. 5 shows another PHEMT according to an embodiment of this application. The PHEMT may be a double doped PHEMT. In addition to the layer structures shown in FIG. 4, the PHEMT may further include a second doped layer 12 and a lower isolation layer 13.

Both the first doped layer 6 and the second doped layer 12 may be δ doped. Therefore, the first doped layer 6 is also referred to as an upper δ doped layer 6, and the second doped layer 12 is also referred to as a lower δ doped layer 12. Both the first doped layer 6 and the second doped layer 12 may be silicon doped. A thin layer of silicon grows on each of the upper isolation layer 5 and the lower barrier layer 3 as doping impurities, to provide two-dimensional electron gas after being ionized. The first doped layer 6 and the second doped layer 12 may both be several atoms thick, and the thickness is less than 2 nm, for example, 1 nm or less than 1 nm. A doping concentration of the first doped layer 6 is greater than a doping concentration of the second doped layer 12.

The lower isolation layer 13 is configured to isolate the second doped layer 12 from the channel layer 4, to prevent doping impurities of the second doped layer 12 from entering the channel layer 4. The lower isolation layer 13 may be made of a gallium arsenide, and the thickness may be 2-6 nm, for example, 4 nm. The lower isolation layer 13 is also referred to as a second isolation layer.

It should be noted that, although the buffer layer 2, the lower barrier layer 3, the upper isolation layer 5, the lower isolation layer 13, and the upper barrier layer 7 may all use aluminum gallium arsenide, doping concentrations of Al in the layers may be the same or different. This is not limited herein.

According to the double δ doped PHEMT provided in this embodiment of this application, because the band gap width of the upper barrier layer 7 and the band gap width of the lower barrier layer 3 are both greater than the band gap width of the channel layer 4, the double δ doped PHEMT has one doped positive junction (the upper barrier layer 7/the first doped layer 6/the upper isolation layer 5/the channel layer 4) and one doped negative junction (the channel layer 4/the lower isolation layer 13/the second doped layer 12/the lower barrier layer 3). When the gate voltage is greater than the turn-on voltage, doping impurities are ionized. Because the band gap width of the barrier layer and the band gap width of the channel layer 4 are different, a conduction band is not continuous, and electrons are transferred to one side of the channel layer to form two-dimensional electron gas. The source 9 and the drain 10 are connected, and the drain current is output.

In some embodiments, the energy band structure of the channel layer is adjusted by using the foregoing solution 3. In the PHEMT shown in FIG. 5, a thickness of the channel layer 4 is greater than 12 nm and less than a critical thickness of a channel epitaxial layer (that is, does not exceed a travel limit of an InGaAs channel epitaxial layer). Therefore, for the double δ doped PHEMT, when the output current is a small current, the conduction band energy level of the channel layer 4 is less than the Fermi energy level. For example, the thickness of the channel layer 4 is 8-30 nm, 12-30 nm, or 15-20 nm, for example, 17 nm, 18 nm, 20 nm, 24 nm, or the like. The thickness or a critical thickness of the channel layer 4 is related to content of indium. Smaller content of indium indicates a larger thickness. For example, the channel layer 4 is made of In₀.₂₂Ga₀.₇₈As, and the thickness is 18 nm.

For the foregoing double δ doped PHEMT, the thickness of the channel layer 4 is increased, so that distribution of electrons and currents in the channel layer 4 can be improved. This avoids accumulation of electrons under the channel layer 4, reduces a current in a thickness direction, and can improve linearity of the PHEMT.

In some other embodiments, the energy band structure of the channel layer is adjusted by using the foregoing solution 2. Therefore, for the double δ doped PHEMT, when the output current is a small current, the conduction band energy level of the channel layer 4 is less than the Fermi energy level.

For example, the doping concentration of the first doped layer 6 is 3.5-4.5 e¹²cm ⁻². The doping concentration of the second doped layer 12 is 3-5 e¹¹cm⁻².

For example, a ratio of the doping concentration of the first doped layer 6 to the doping concentration of the second doped layer 12 is greater than a preset value. The preset value is not less than 6, for example, 9, 10, 15, 30, 70, 100, 150, or the like.

For another example, the doping concentration of the first doped layer 6 is 4-6 e¹²cm ⁻². The doping concentration of the second doped layer 12 is 2 e⁸cm ⁻² to 3 e¹¹cm ⁻², 1 e⁶cm ⁻² to 1 e¹¹cm ⁻², or 1 e⁶cm ⁻² to 1 e⁸cm ⁻².

For another example, the doping concentration of the first doped layer 6 is 3.5-4.5 e¹²cm ⁻², 4.5-6 e¹²cm⁻², or 4.6-5.5 e¹²cm ⁻². The doping concentration of the second doped layer 12 is 2 e⁸cm ⁻² to 3 e¹¹cm⁻².

For the double δ doped PHEMT, the doping concentrations of the upper/lower δ doped layers and the ratio of the doping concentrations are adjusted, so that the gradient of the energy level of the channel layer 4 caused by the second doped layer 12 is reduced. Therefore, when the device operates under a low current, the conduction band energy level of the channel layer 4 is less than the Fermi energy level. This improves linearity of the device.

In some other embodiments, the energy band structure of the channel layer is adjusted by using the foregoing solution 2 and solution 3. Therefore, for the double δ doped PHEMT, when the output current is a small current, the conduction band energy level of the channel layer 4 is less than the Fermi energy level. For example, the thickness of the channel layer is 18 nm. The doping concentration of the first doped layer 6 is 3.5-4.5 e¹²cm ⁻². The doping concentration of the second doped layer 12 is 2 e⁸cm ⁻² to 3 e¹¹cm ⁻². Alternatively, a ratio of the doping concentration of the first doped layer 6 to the doping concentration of the second doped layer 12 is set to be greater than a preset value. The preset value is not less than 6, for example, 9.

For the double δ doped PHEMT, the doping concentrations of the upper/lower doped layers and the ratio of the doping concentrations are adjusted, so that the gradient of the energy level of the channel layer 4 caused by the lower doped layer is reduced. Therefore, when the device operates under a low current, the conduction band energy level of the channel layer 4 is less than the Fermi energy level. This improves linearity of the device.

In some other embodiments, the energy band structure of the channel layer is adjusted by using a combination of the solution 2 and/or the solution 3 and the adjustment of the thickness of the upper barrier layer and/or the upper isolation layer. Therefore, for the double δ doped PHEMT, when the output current is a small current, the conduction band energy level of the channel layer 4 is less than the Fermi energy level.

For example, a thickness of the upper barrier layer 7 is 3-7 nm. A thickness of the upper isolation layer 5 is 3-5 nm. The doping concentration of the first doped layer 6 is 3.0-4.5 e¹²cm ⁻². The doping concentration of the second doped layer 12 is 3-5 e¹¹cm ⁻². The thickness of the channel layer is 18 nm.

For another example, a thickness of the upper barrier layer 7 is 3-7 nm. A thickness of the upper isolation layer 5 is 3-5 nm. The doping concentration of the first doped layer 6 is 3.0-4.5 e¹²cm ⁻². The doping concentration of the second doped layer is 2 e⁸cm ⁻² to 3 e¹¹cm ⁻². The thickness of the channel layer is 14-20 nm.

For another example, a thickness of the upper barrier layer 7 is 5 nm. A thickness of the upper isolation layer 5 is 4 nm. The doping concentration of the first doped layer 6 is 3.0-4.5 e¹²cm ⁻². The doping concentration of the second doped layer is 2 e⁸cm ⁻² to 3 e¹¹cm ⁻². The thickness of the channel layer is 14-20 nm.

Further, in the foregoing embodiments, when the PHEMT is under a small output current, the conduction band energy level of the channel layer 4 substantially decreases in the thickness direction.

In some other embodiments, each layer structure in FIG. 4 or FIG. 5 may alternatively be made of another material and have another thickness, for example, may be made of a ternary, quaternary, or polynary compound of gallium arsenide. For another example, the PHEMT is a gallium phosphide (GaP)-based PHEMT.

It should be noted that, in the descriptions in FIG. 4 and FIG. 5, the upper doped layer or the upper δ doped layer corresponds to the first doped layer 6, and the lower doped layer or the lower δ doped layer corresponds to the second doped layer 12.

It should be further noted that, for clear description, thicknesses of layers in FIG. 4 and FIG. 5 do not correspond to actual thicknesses or thickness ratios of the layers, and a specific thickness range is subject to a thickness specified for the foregoing layers.

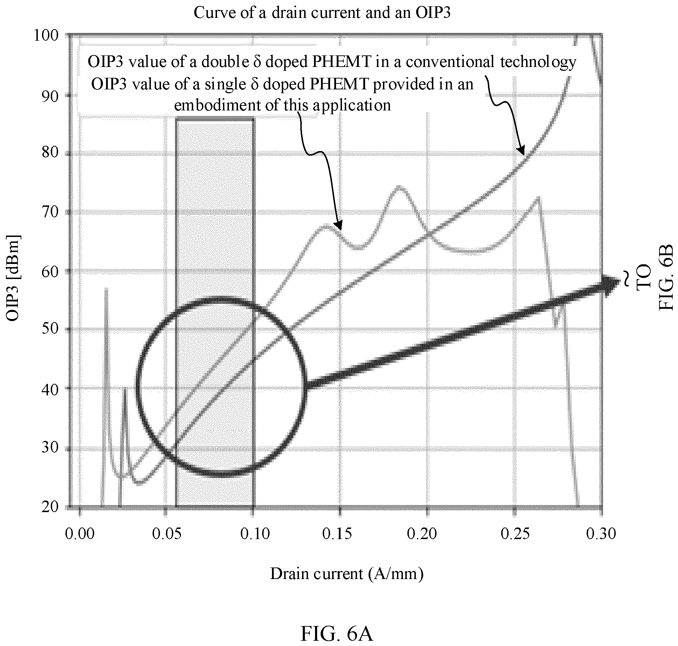

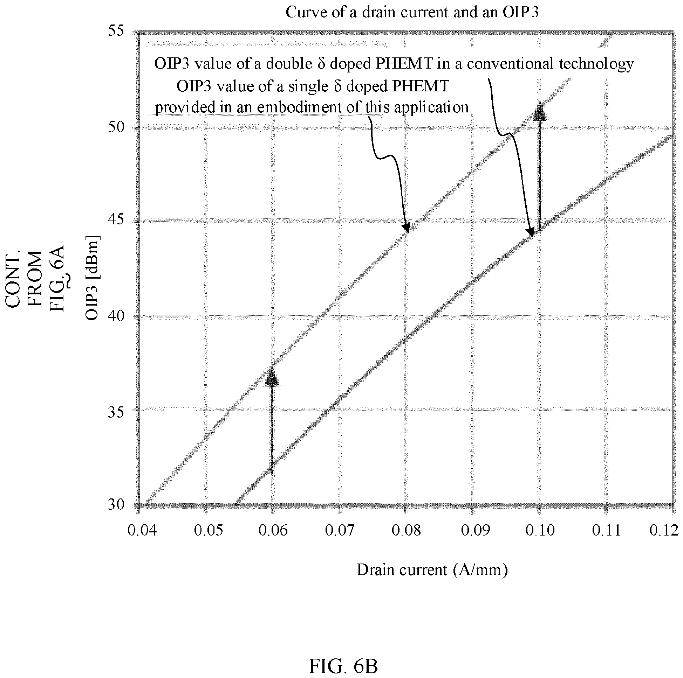

Compared with the conventional technology, an OIP3 value of the single δ doped PHEMT provided in this embodiment of this application significantly increases. When an output drain current is 60-100 mA, the OIP3 value of the single δ doped PHEMT increases by more than 5 dBm. Specific data is shown in FIG. 6. FIG. 6 compares a simulation result of an OIP3 value of the double δ doped PHEMT in the conventional technology with a simulation result of the OIP3 value of the single δ doped PHEMT provided in this embodiment of this application. It may be learned that, compared with the double δ doped PHEMT in the conventional technology, the OIP3 value of the single δ doped PHEMT provided in this embodiment of this application increases by more than 5 dBm when an output current is 50-200 mA.

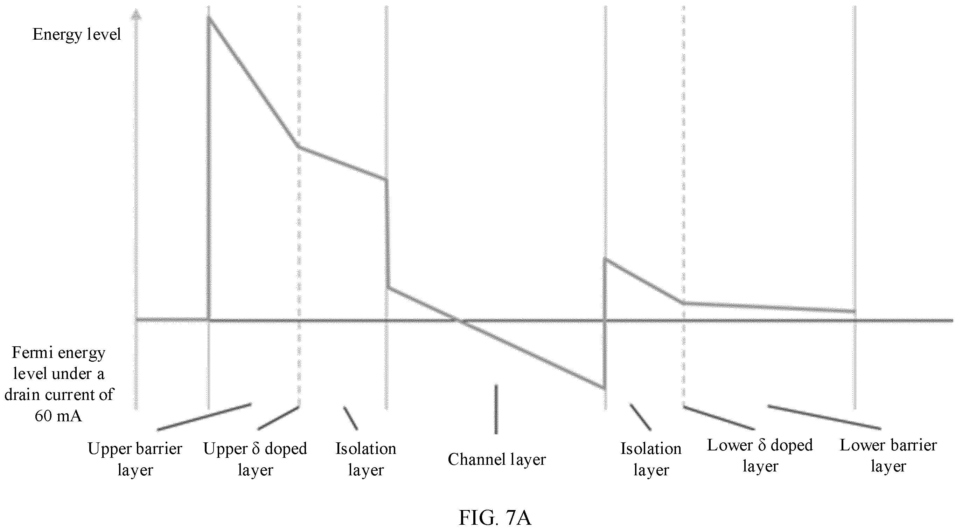

With reference to FIG. 7A to FIG. 7C, the following describes a principle of improving linearity of a PHEMT through single δ doping.

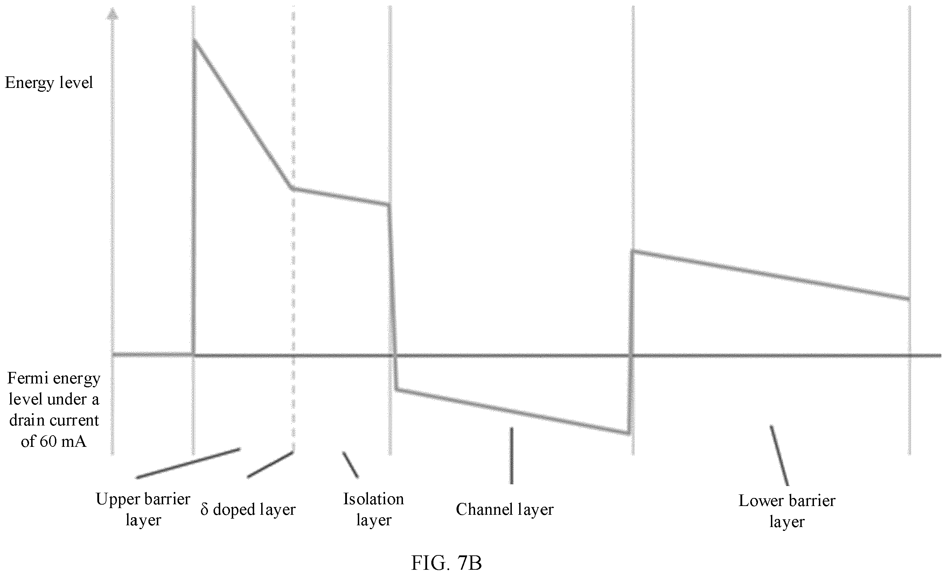

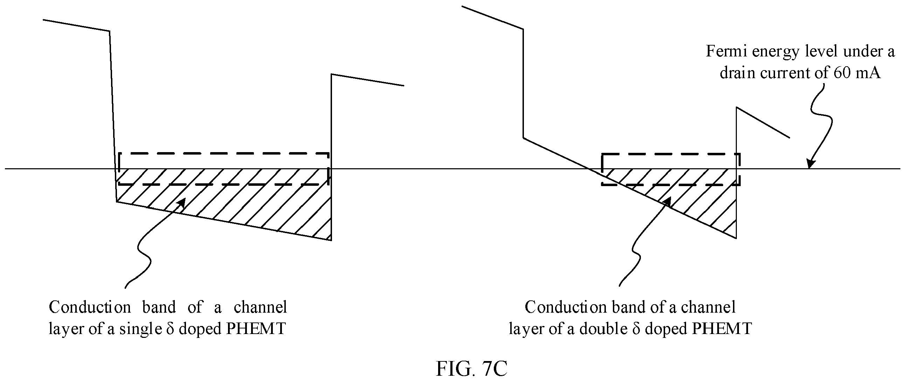

FIG. 7A is a diagram of an energy band of the double δ doped PHEMT in the conventional technology. FIG. 7B is a diagram of an energy band of a single δ doped PHEMT according to an embodiment of this application. FIG. 7C compares a conduction band structure of the double δ doped PHEMT and a conduction band structure of the single δ doped PHEMT at a channel layer. It should be understood that, as a gate voltage increases, a Fermi energy level increases. FIG. 7A to FIG. 7C all show a location of the Fermi energy level when a drain current (namely, an output current) is 60 mA.

Because space charges are distributed in a centralized manner at a δ doping location, an energy band on the left side of the δ doping location is bent. When the output current is 60 mA, it may be learned from an energy band structure that, the conduction band structure of the channel layer of the single δ doped PHEMT is closer to a quadrilateral, and the conduction band structure of the double δ doped PHEMT is closer to a triangle, as shown by shadow regions in FIG. 7C. Because an electron concentration in the channel layer is proportional to an area of a polygon enclosed by a conduction band and a Fermi energy level, the conduction band structure of the quadrilateral has higher linearity than the conduction band structure of the triangle in a changing process of the gate voltage.

Electrons in the channel layer of the single δ doped PHEMT are all provided by the upper δ doped layer. Therefore, to obtain a same output current, the conduction band of the channel layer of the single δ doped PHEMT is far lower than the Fermi energy level compared with the conduction band of the channel layer of the double δ doped PHEMT. Fermi-Dillac distribution occurs in electrons near the Fermi energy level. To be specific, a probability of electron occurrence near the Fermi energy level (as shown by a dashed-line box region in FIG. 7C) is 0.5, and a probability of electron occurrence lower than the Fermi energy level is 1. In this way, the probability of electron occurrence near the Fermi energy level is nonlinear to some extent as the gate voltage changes. However, an area occupied by electrons near the Fermi energy level has a smaller proportion in the entire conduction band structure of the channel layer of the single δ doped PHEMT. Therefore, the single δ doping design in which the conduction band is far lower than the Fermi energy level can provide higher linearity.

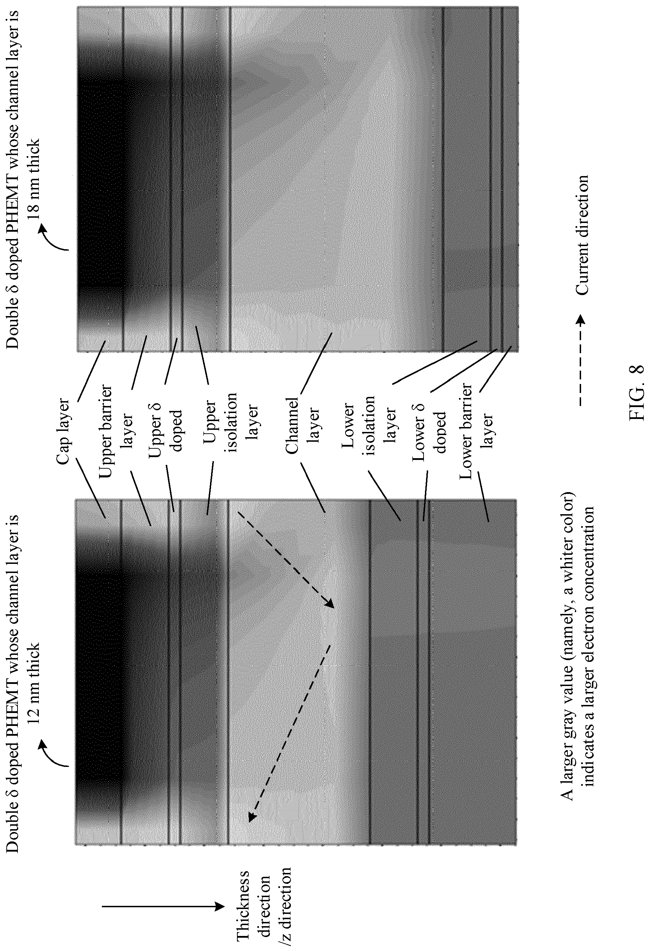

With reference to FIG. 8, the following describes a principle of improving linearity of a PHEMT by increasing a thickness of a channel layer.

FIG. 8 is a diagram of electron concentration distribution of double δ doped PHEMTs whose channel layers are respectively 12 nm and 18 nm thick under an output current of 60 mA/mm. It may be learned from FIG. 8 that, when the PHEMT operates under an output current of 60 mA/mm, a large quantity of electrons are gathered under the channel layer of the PHEMT whose channel layer is 12 nm thick, and a current in the channel layer has a large z-direction component. In comparison, when the PHEMT operates, electrons are distributed more evenly in the channel layer of the PHEMT whose channel layer is 18 nm thick. This reduces a z-direction component of a current in the channel layer, reduces complexity of controlling a channel current by using a gate, and improves linearity of the PHEMT.

The following describes an application scenario of the PHEMT provided in embodiments of this application.

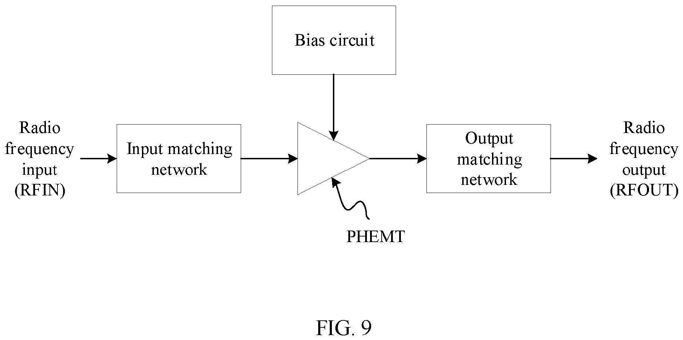

An embodiment of this application further provides an LNA. As shown in FIG. 9, the LNA includes an input matching network, a bias circuit, a PHEMT, and an output matching network. The PHEMT may be the PHEMT shown in FIG. 4 or FIG. 5. The bias circuit is configured to provide a bias voltage for proper operation of the PHEMT, that is, set a gate, a source, and a drain of the PHEMT at a required potential. The input matching network is configured to implement matching between an output impedance of a signal source and an input impedance of the LNA, so that the LNA obtains a maximum excitation power. The output matching network is configured to convert an external load resistance into an optimal load resistance used by an amplifier, to ensure a maximum output power.

An embodiment of this application further provides a receiver or a transceiver. The receiver or the transceiver may include the LNA shown in FIG. 9. Optionally, the receiver or the transceiver may further include a duplexer, a band-pass filter, a digital-to-analog converter (ADC), and the like.

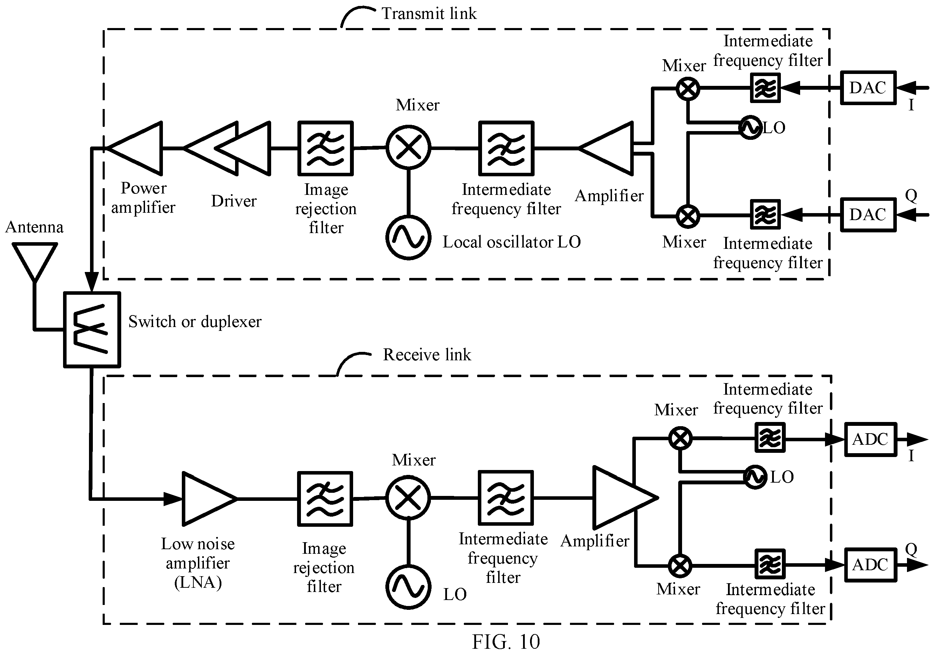

The LNA may be applied to a radio frequency system. As shown in FIG. 10, the radio frequency system may be divided into a transmit link and a receive link. In an application scenario of this application, a low noise amplifier LNA in the receive link of the radio frequency system may be the LNA shown in FIG. 9, and is configured to amplify a signal received by an antenna.

The transmit link may include a power amplifier (power amplifier, PA), a driver (driver), at least one filter (filter), at least one mixer (mixer), at least one local oscillator (local oscillate, LO), at least one amplifier (amplifier, AMP), and the like. The receive link may include the low noise amplifier LNA, at least one filter, at least one mixer, at least one local oscillator (local oscillate, LO), at least one amplifier, and the like. The at least one filter may include an image rejection filter (image rejection filter), an intermediate frequency filter (IF filter), another filter, or the like.

It should be understood that FIG. 10 is merely an example for description. The radio frequency system may alternatively be another circuit structure, and may alternatively include fewer components than those in FIG. 10. This is not limited herein.

This application further provides a radio frequency circuit. The circuit includes the PHEMT shown in FIG. 4 or FIG. 5 or includes the LNA shown in FIG. 9, and is applied to the wireless communication field, and is configured to process a signal received by an antenna and/or control an antenna to transmit a signal.

This application further provides a radio frequency chip. The radio frequency chip is configured to: process a signal received by a receive antenna, send the signal to a processor, receive an instruction of the processor, and control a transmit antenna to transmit a signal.

This application further provides an electronic device. The electronic device may be a device having a radio frequency function or a wireless communication function, such as a mobile phone, a tablet computer, an e-reader, a television, a notebook computer, a digital camera, an in-vehicle device, a wearable device, a base station, or a router. The electronic device may include at least one of the PHEMT, the LNA, the radio frequency system, the radio frequency circuit, and the radio frequency chip described above.

In conclusion, the foregoing embodiments are merely intended for describing the technical solutions of this application, but not for limiting this application. Although this application is described in detail with reference to the foregoing embodiments, a person of ordinary skill in the art should understand that modifications to the technical solutions recorded in the foregoing embodiments or equivalent replacements to some technical features thereof may still be made, without departing from the scope of the technical solutions of embodiments of this application.

## Claims

1. A pseudomorphic high electron mobility transistor PHEMT, comprising:
a channel layer;
a lower barrier layer and an upper barrier layer that are respectively disposed on two sides of the channel layer, wherein the lower barrier layer is connected to the channel layer; and
a first isolation layer and a first doped layer that are disposed between the channel layer and the upper barrier layer, wherein the first isolation layer is configured to isolate the first doped layer from the channel layer, and the first doped layer is configured to provide two-dimensional electron gas; and
when an output current of the PHEMT is less than a first threshold, a conduction band energy level of the channel layer is less than a Fermi energy level.

2. The PHEMT according to claim 1, wherein the lower barrier layer is directly connected to the channel layer.

3. The PHEMT according to claim 2, wherein the first doped layer is silicon doped, and a doping concentration is 3 e¹²cm ⁻²to 5 e¹²cm⁻².

4. The PHEMT according to claim 1, wherein the lower barrier layer is connected to the channel layer through a second isolation layer and a second doped layer, the second isolation layer is configured to isolate the channel layer from the second doped layer, and the second doped layer is configured to provide two-dimensional electron gas.

5. The PHEMT according to claim 4, wherein a doping concentration of the first doped layer is 3.5 e¹²cm ⁻² to 4.5 e¹²cm ⁻², and a doping concentration of the second doped layer is 3 e¹¹cm ⁻² to 5 e¹¹cm ⁻².

6. The PHEMT according to claim 4, wherein a ratio of a doping concentration of the first doped layer to a doping concentration of the second doped layer is greater than a preset value.

7. The PHEMT according to claim 6, wherein the preset value is greater than 9.

8. The PHEMT according to any one of claims 3 to 7, wherein values of the concentration of the first doped layer and the concentration of the second doped layer enable the conduction band energy level of the channel layer to be less than the Fermi energy level when the PHEMT is in an on state.

9. The PHEMT according to any one of claims 1 to 8, wherein a thickness of the channel layer is 15-20 nm.

10. The PHEMT according to any one of claims 1 to 9, wherein when the output current of the PHEMT is less than a second threshold, the conduction band energy level of the channel layer decreases substantially in a thickness direction.

11. The PHEMT according to any one of claims 1 to 10, further comprising: a cap layer, a source, a drain, and a gate, wherein the cap layer is disposed on a side of the upper barrier layer away from the channel layer and provided with a through hole for providing ohmic contact, the gate is disposed in the through hole, and the source and the drain are both disposed on a side of the cap layer away from the upper barrier layer, and are respectively located on two sides of the through hole.

12. The PHEMT according to any one of claims 1 to 11, wherein the channel layer is made of indium gallium arsenide, and the upper barrier layer, the lower barrier layer, or the isolation layer is made of aluminum gallium arsenide.

13. A low noise amplifier, comprising the PHEMT according to any one of claims 1 to 12.

14. A radio frequency circuit, comprising the low noise amplifier according to claim 13.

15. A radio frequency chip, comprising at least one of the PHEMT according to any one of claims 1 to 12, the low noise amplifier according to claim 13, and the radio frequency circuit according to claim 14.

16. An electronic device, comprising at least one of the PHEMT according to any one of claims 1 to 12, the low noise amplifier according to claim 13, the radio frequency circuit according to claim 14, and the radio frequency chip according to claim 15.
